# EUROPEAN PATENT APPLICATION

(11) **EP 2 048 713 A2**
(43) Date of publication of application: **15.04.2009**
(21) Application number: 08163599.7
(22) Date of filing: 03.09.2008
(51) Int. Cl.: H01L 27/24, G11C 13/00, H01L 45/00

(54) **Multi-layer electrode, cross point memory array and method of manufacturing the same**

(30) Priority: 10.10.2007 KR 20070102146; 05.03.2008 KR 20080020588
(71) Applicant: Samsung Electronics Co., Ltd., Suwon-si Gyeonggi-do 443-742 (KR)
(72) Inventor: Lee, Changbum, Gyeonggi-do (KR); Park, Youngsoo, Gyeonggi-do (KR); Lee, Myoungjae, Gyeonggi-do (KR); Genrikh, Stefanovich, Gyeonggi-do (KR); Kim, Kihwan, Gyeonggi-do (KR)
(74) Representative: Greene, Simon Kenneth

(57) **Abstract**

Provided may be a multi-layer electrode, a cross point resistive memory array and method of manufacturing the same. The array may include a plurality of first electrode lines (21) arranged parallel to each other; a plurality of second electrode lines (25) crossing the first electrode lines and arranged parallel to each other; and a first memory resistor (22) at intersections between the first electrode lines and the second electrode lines, wherein at least one of the first electrode lines and the second electrode lines have a multi-layer structure including a first conductive layer and a second conductive layer formed of a noble metal.

## Description

### BACKGROUND OF THE INVENTION

Example embodiments relate to a multi-layer electrode, a memory device and method of manufacturing the same. Other example embodiments relate to a multi-layer electrode, a cross point resistive memory array and method of manufacturing the same.

Semiconductor memory devices may include a plurality of memory cells connected in circuits. In a dynamic random access memory (DRAM), an example of a conventional semiconductor memory device, a unit memory cell may include one switch and one capacitor. The DRAM may have an increased integration density and a faster operating speed. However, the DRAM loses all stored data when the power is shut off. On the contrary, an example of a nonvolatile memory device, in which stored data may be retained even when the power is shut off, may be a flash memory device. However, the flash memory device has a lower integration density and a slower operating speed than the DRAM.

Examples of nonvolatile memory devices include a magnetic random access memory (MRAM), a ferroelectric random access memory (FRAM), a phase-change random access memory (PRAM), and a resistance random access memory (RRAM). The RRAM uses the variable resistance characteristics of a transition metal oxide whose resistance varies depending on certain conditions. A metal layer formed of a single metal may be used as an electrode of a resistive memory device. In this regard, a noble metal layer may be used, e.g., Pt.

### SUMMARY OF THE INVENTION

Example embodiments provide a multi-layer electrode, a cross point resistive memory array and method of manufacturing the same. Other example embodiments provide a multi-layer electrode, a cross point resistive memory array that may prevent or reduce a drop in voltage due to an electrode structure having a multi-layer structure and a method of manufacturing the same.

According to example embodiments, a cross point memory array may include a plurality of first electrode lines arranged parallel to each other, a plurality of second electrode lines crossing the first electrode lines and arranged parallel to each other, and a first memory resistor at intersections between the first electrode lines and the second electrode lines, wherein at least one of the first electrode lines and the second electrode lines have a multi-layer structure including a first conductive layer and a second conductive layer formed of a noble metal.

According to example embodiments, a method of manufacturing a cross point memory array may include providing a plurality of first electrode lines arranged parallel to each other, providing a plurality of second electrode lines crossing the first electrode lines and arranged parallel to each other, and forming a first memory resistor at intersections between the first electrode lines and the second electrode lines, wherein at least one of the first electrode lines and the second electrode lines have a multi-layer structure including a first conductive layer and a second conductive layer formed of a noble metal.

The specific resistance of the first conductive layer may be lower than the specific resistance of the second conductive layer. The first conductive layer may be formed of any one selected from Al, Mo, Cu and Ag. The second conductive layer may be a layer formed of the noble metal or an alloy layer including the noble metal. The noble metal may be any one selected from Pt, Au, Pd, Ir and Ag. The second conductive layer may be on the first conductive layer, or the first conductive layer may be on the second conductive layer. The second conductive layer may extend in a line pattern. The second conductive layer may be configured as dot patterns at the intersections.

The array may further include a first switch structure at the intersections between the first electrode lines and the second electrode lines and for adjusting a current flow towards the first memory resistor. The array may further include a first intermediate electrode between the first memory resistor and the first switch structure. The first memory resistor, the first intermediate electrode, the first switch structure and the second electrode lines may be sequentially formed on the first electrode lines. The first switch structure, the first intermediate electrode, the first memory resistor and the second electrode may be sequentially formed on the first electrode lines. The first switch structure may be any one selected from a diode, a threshold switching device, and a varistor. The diode may be an oxide diode.

The first memory resistor may include at least one selected from Ni oxide, Cu oxide, Ti oxide, Co oxide, Hf oxide, Zr oxide, Zn oxide, W oxide, Nb oxide, TiNi oxide, LiNi oxide, Al oxide, InZn oxide, V oxide, SrZr oxide, SrTi oxide, Cr oxide, Fe oxide and Ta oxide. The array may further include a plurality of third electrode lines crossing the second electrode lines and arranged parallel to each other, and a second memory resistor at intersections between the second electrode lines and the third electrode lines, wherein the third electrode lines may have a multi-layer structure including the first conductive layer and the second conductive layer.

The array may further include a second switch structure at the intersections between the second electrode lines and the third electrode lines and for adjusting a current flow towards the second memory resistor. The array may further include a second intermediate electrode between the second memory resistor and the second switch structure. The second memory resistor, the second intermediate electrode, the second switch structure and the third electrode line may be sequentially formed on the second electrode lines.

The second switch structure, the second intermediate electrode, the second memory resistor and the third electrode line may be sequentially formed on the second electrode lines. The second switch structure may be any one selected from a diode, a threshold switching device, and a varistor. The diode may be an oxide diode. The array may be a multi-layer cross point array device having a one diode-one resistor (1D-1R) cell structure. The first memory resistor may include an element that may be reversibly converted from a higher resistance state to a lower resistance state, or from a lower resistance state to a higher resistance state. The first memory resistor may include an element that may be irreversibly converted from a higher resistance state to a lower resistance state.

According to example embodiments, a multi-layer electrode may include a first conductive layer, and a second conductive layer formed of a noble metal. The specific resistance of the first conductive layer may be lower than the specific resistance of the second conductive layer. The first conductive layer may be formed of any one selected from Al, Mo, Cu and Ag. The second conductive layer may be a layer formed of the noble metal or an alloy layer including the noble metal. The noble metal may be any one selected from Pt, Au, Pd, lr and Ag. The second conductive layer may be on the first conductive layer, or the first conductive layer may be on the second conductive layer. The first conductive layer may extend in a line pattern, and the second conductive layer may extend in a line pattern or may be configured as at least one dot pattern.

### BRIEF DESCRIPTION OF THE DRAWINGS

Example embodiments will be more clearly understood from the following detailed description taken in conjunction with the accompanying drawings. FIGS. 1A-7 represent non-limiting, example embodiments as described herein.
FIGS. 1A and 1B are each a cross-sectional view illustrating a unit device of a memory device according to example embodiments;
FIGS. 2 and 3 perspective views of cross point resistive memory arrays according to example embodiments;
FIGS. 4A and 4B are circuit views of the memory array of FIG. 3;
FIG. 5 is a plan view of a memory array according to example embodiments;
FIG. 6 is a perspective view for illustrating a phenomenon whereby a problem with a drop in voltage may be overcome in a memory array, according to example embodiments; and
FIG. 7 is a perspective view of a memory array according to example embodiments.

It should be noted that these Figures are intended to illustrate the general characteristics of methods, structure and/or materials utilized in certain example embodiments and to supplement the written description provided below. These drawings are not, however, to scale and may not precisely reflect the precise structural or performance characteristics of any given embodiment, and should not be interpreted as defining or limiting the range of values or properties encompassed by example embodiments. For example, the relative thicknesses and positioning of molecules, layers, regions and/or structural elements may be reduced or exaggerated for clarity. The use of similar or identical reference numbers in the various drawings is intended to indicate the presence of a similar or identical element or feature.

### DETAILED DESCRIPTION OF EXAMPLE EMBODIMENTS

Hereinafter, example embodiments will be described in detail by explaining exemplary embodiments with reference to the attached drawings. In the drawings, the thicknesses and widths of layers or regions are exaggerated for clarity.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Like numbers indicate like elements throughout. As used herein the term "and/or" includes any and all combinations of one or more of the associated listed items.

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

According to example embodiments, an electrode that may be in contact with a memory resistor or a switch may include a multi-layer structure including a noble metal layer and a metal layer having lower specific resistance than the noble metal layer. Example embodiments provide a resistive memory device including a memory resistor and a cross point memory array including the resistive memory device, wherein at least one of upper and lower electrodes of the resistive memory device includes a noble layer and a metal layer having lower specific resistance than the noble metal layer.

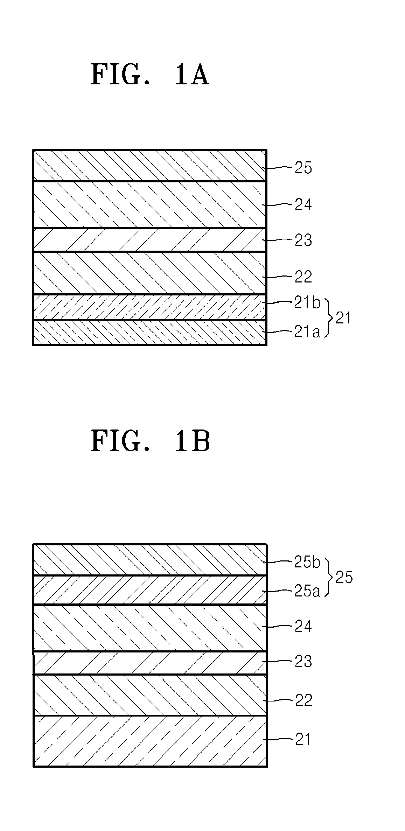

FIGS. 1A and 1B are each a cross-sectional view illustrating a unit device of a memory device according to example embodiments. The unit device of the memory device according to example embodiments may have a one switch-one resistor (1S-1R) structure, for example, a one diode-one resistor (1 D-1 R) structure. Referring to FIG. 1A, a memory resistor 22, a switch structure 24 and a second electrode 25 may be sequentially formed on a first electrode 21. An intermediate electrode 23 may be further formed between the memory resistor 22 and the switch structure 24. The first electrode 21 may be formed as a multi-layer structure including a first conductive layer 21 a composed of metal having a relatively low specific resistance and a second conductive layer 21 b composed of noble metal between the first conductive layer 21 a and the memory resistor 22. The specific resistance of the first conductive layer 21 a may be lower than that of the second conductive layer 21 b, and a material used for forming the first conductive layer 21 a may be more inexpensive than a material used for forming the second conductive layer 21 b. In example embodiments, the first conductive layer 21 a may be formed of noble metal. Also, in example embodiments, the specific resistance of the first conductive layer 21 a may be lower than that of the second conductive layer 21 b, and the material used for forming the first conductive layer 21 a may be more inexpensive than a material used for forming the second conductive layer 21 b. The second electrode 25 may also be formed as a multi-layer structure including a noble metal conductive layer and a metal layer having lower specific resistance than that of the noble metal conductive layer.

Referring to FIG. 1B, a memory resistor 22, a switch structure 24 and a second electrode 25 may be sequentially formed on a first electrode 21. An intermediate electrode 23 may be further formed between the memory resistor 22 and the switch structure 24. The second electrode 25 may be formed on the switch structure 24, and may be formed as a multi-layer structure including a third conductive layer 25a composed of noble metal and a fourth conductive layer 25b composed of metal having lower specific resistance than that of the noble metal used for forming the third conductive layer 25a. For example, the second electrode 25 may have a reverse structure of the first electrode 21 illustrated in FIG. 1A. However, the second electrode 25 may also have the same stack structure as the first electrode 21 illustrated in FIG. 1A. In addition, the first electrode 21 illustrated in FIG. 1B and the first electrode 21 illustrated in FIG. 1A may have the same stack structure.

As described above, in the memory device according to example embodiments, at least one of the first electrode 21 and the second electrode 25, which may be in contact with the memory resistor 22 or the switch structure 24, may be configured as a multi-layer structure. Hereinafter, materials used for forming respective layers of each of the memory devices illustrated in FIGS. 1A and 1B will be described.

The second conductive layer 21 b and the third conductive layer 25a may each be formed of a material having a relatively high work function, for example, a noble metal (e.g., Pt, Au, Pd, Ir or Ag). The first conductive layer 21 a and the fourth conductive layer 25b may each be formed of a material having lower specific resistance than that of a material used for forming the second conductive layer 21 b and the third conductive layer 25a. For example, the first conductive layer 21 a and the fourth conductive layer 25b may each be formed of a material having specific resistance equal to or less than about 9×10⁻⁸Ω·m, e.g., Al, Mo, Cu or Ag. This material may be economically advantageous and may have a relatively low specific resistance, thereby preventing or reducing a drop in voltage and lowering the manufacturing costs thereof. Because silver (Ag) may be a noble metal, silver (Ag) may have relatively low specific resistance and may be inexpensive. Accordingly, when a noble metal that is more expensive and has higher specific resistance than Ag is used for forming the second conductive layer 21 b or the third conductive layer 25a, silver (Ag) may be used for forming the first conductive layer 21 a or the fourth conductive layer 25b.

The intermediate electrode 23 may electrically connect the memory resistor 22 to the switch structure 24. Without the intermediate electrode 23, the switch structure 24 may function as a resistor, and thus, problems may arise with the operation of the memory device. If the switch structure 24 is assumed to be a diode, when the memory resistor 22 is set without the intermediate electrode 23, the switch structure 24 may be damaged, and accordingly, the rectifying characteristics of the switching structure 24 may be lost. The intermediate electrode 23 may be formed of an electrode material used for semiconductor devices. For example, Al, Hf, Zr, Zn, W, Co, Au, Ag, Pd, Pt, Ru, Ir, Ti or a conductive metal oxide may be used for forming the intermediate electrode 23, but example embodiments are not limited thereto. In example embodiments, the intermediate electrode 23 may have the same structure of the first electrode 21 or the second electrode 25.

The memory resistor 22 may be formed of a variable resistance material used for forming resistive memory devices. The variable resistance material may have two or more resistance characteristics according to a current supplied to the variable resistance material. In example embodiments, the memory resistor 22 may be a transition metal oxide (TMO), e.g., Ni oxide, Cu oxide, Ti oxide, Co oxide, Hf oxide, Zr oxide and Zn oxide. In addition, W oxide, Nb oxide, TiNi oxide, LiNi oxide, Al oxide, InZn oxide, V oxide, SrZr oxide, SrTi oxide, Cr oxide, Fe oxide and Ta oxide may be used for forming the memory resistor 22.

The switch structure 24 may be configured as a diode, a threshold switching device, or a varistor, which may be used for semiconductor devices. When the switch structure 24 is configured as a diode, the switch structure 24 may be configured as a bilayer structure including an n-type semiconductor layer and a p-type semiconductor layer, e.g., a bilayer structure including an n-type oxide layer and a p-type oxide layer. For example, the switch structure 24 may be configured as a stack structure in which a p-type oxide layer, e.g., a CuO layer, and an n-type semiconductor layer, e.g., InZnO layer, may be sequentially formed, or alternatively may be configured as a stack structure in which a p-type oxide layer, e.g., an NiO layer, and an n-type oxide layer, e.g., TiO₂, may be sequentially formed. With regard to the CuO layer, due to a Cu deficiency that is spontaneously generated, O²⁻, which is not coupled to Cu, may act as a donor, and thus, the CuO layer may be a p-type semiconductor layer. With regard to the InZnO layer, due to the zinc (Zn) interstitial and oxygen (O) vacancy which may be spontaneously generated, Zn²⁺, which exists out of a lattice or is not coupled to O, may act as an acceptor, and thus, the InZnO layer may be an n-type semiconductor layer. Oxide layers, which may be formed of an amorphous material and may be more easily formed at room temperature, may be used for manufacturing the switch structure 24, but oxide layers formed of a crystalline material may also be used. With regard to a silicon diode, because the silicon diode needs to be manufactured at a relatively high temperature of about 800°C, various problems may arise at a higher temperature. Thus, in example embodiments, an oxide layer, which may be more easily formed at room temperature, may be used for forming the switch structure 24. A contact electrode (not shown) may be formed between the switch structure 24 and the second electrode 25. The resistive memory devices of FIGS. 1A and 1B may be manufactured by a semiconductor process technique, e.g., chemical vapor deposition (CVD) or physical vapor deposition (PVD).

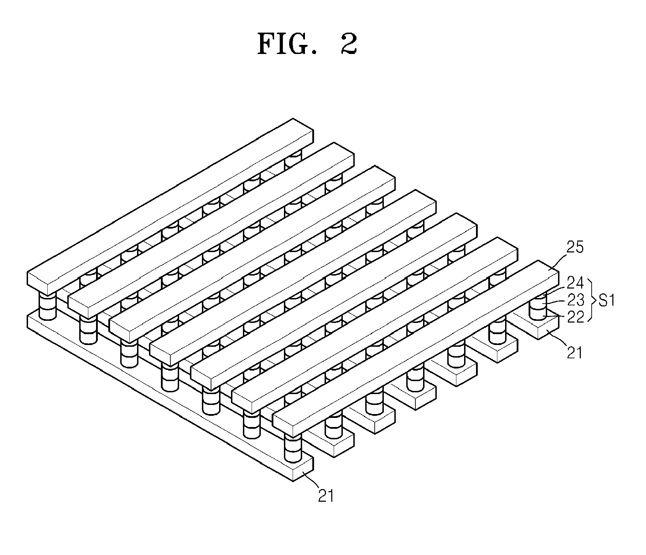

FIG. 2 is a perspective view of a cross point resistive memory array according to example embodiments. Referring to FIG. 2, the cross point resistive memory array may include a plurality of first electrodes 21 and a plurality of second electrodes 25, wherein the first electrodes 21 may be arranged parallel to each other in a first direction and the second electrodes 25 cross the first electrodes 21. In addition, a plurality of stack structures S1 may be further formed at intersections between the first electrode 21 and the second electrode 25. The stack structures S1 may each include a first memory resistor 22, a first intermediate electrode 23 and a first switch structure 24, which may be sequentially formed on the first electrode 21. The locations of the first memory resistor 22 and the first switch structure 24 may be reversed.

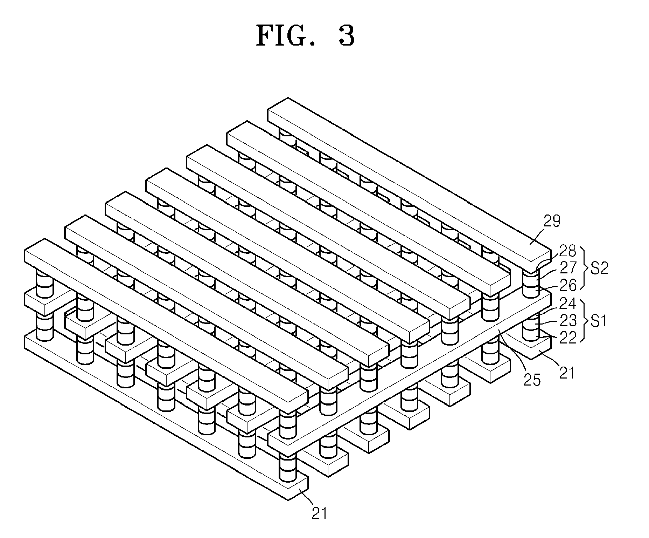

The first memory resistor 22, the first intermediate electrode 23 and the first switch structure 24 may correspond to the memory resistor 22, the intermediate electrode 23 and the switch structure 24 which are illustrated in FIG. 1A, respectively. At least one of the first electrode 21 and the second electrode 25 may be configured as a multi-layer structure including a conductive layer formed of noble metal and a conductive layer formed of metal having a lower specific resistance than that of the noble metal. For example, the first electrode 21 illustrated in FIG. 2 may have the same structure as the first electrode 21 illustrated in FIG. 1A, and the second electrode 25 illustrated in FIG. 2 may have the same structure as the second electrode 25 illustrated in FIG. 1B. A second switch structure, a second intermediate electrode, a second memory resistor and a third electrode may be further formed on the second electrode 25 illustrated in FIG. 2. This example is illustrated in FIG. 3.

Referring to FIG. 3, a cross point resistive memory array according to example embodiments may include a plurality of first electrodes 21, a plurality of first stack structures S1 and a plurality of second electrodes 25, similar to FIG. 2. In addition, a plurality of third electrodes 29 may further be formed a predetermined or given distance apart from the upper surfaces of the second electrodes 25. The third electrodes 29 may each have a wire shape, and may be formed at equal distances to each other. In addition, the third electrodes 29 may cross the second electrodes 25, and may be perpendicular to the second electrodes 25. The third electrodes 29 may have the same structure as the first electrode 21 or the second electrode 25. A plurality of second stack structures S2 may be disposed at intersections between the second electrode 25 and the third electrodes 29. The second stack structures S2 and the first stack structures S1 may have the same stack structure or may have structures with reflection symmetry from a circuit point of view.

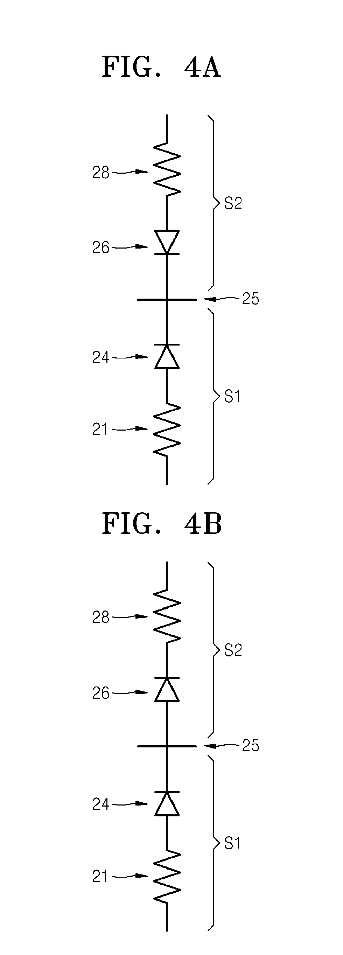

For example, when the first stack structures S1 include a stack structure in which an first intermediate electrode 23 and a first switch structure 24 is sequentially formed on the first memory resistor 22, the second stack structures S2 may have a structure in which a second intermediate electrode 27 and a second memory resistor 28 may be sequentially formed on the second switch structure 26. The second intermediate electrode 27 may be formed of the same material as the first intermediate electrode 23, and the second switch structure 26 may be a diode. In example embodiments, the second switch structure 26 and the first switch structure 24 may have the same stack structure or may have structures with reflection symmetry from a circuit point of view. For example, the first stack structures S1, the second electrode 25 and the second stack structures S2 may be configured as structures illustrated in FIG. 4A or 4B from a circuit point of view.

In FIGS. 4A and 4B, the rectification directions of the first and second switch structures 24 and 26 may be changed. In addition, in the first stack structures S1, the locations of the first memory resistor 22 and the first switch structure 24 may be reversed, and in the second stack structures S2, the locations of the second memory resistor 28 and the second switch structure 26 may be reversed.

In addition, in FIG. 4A, because the first and second switch structures 24 and 26 have structures with reflection symmetry about the second electrode 25 from a circuit point of view, information may be simultaneously recorded on the first and second memory resistors 22 and 28 by using the second electrodes 25 as a common bit line. On the other hand, in FIG. 4B, because the first and second switch structures 24 and 26 have the same rectification direction, information may be recorded on any one of the first and second memory resistors 22 and 28 by using one programming operation only.

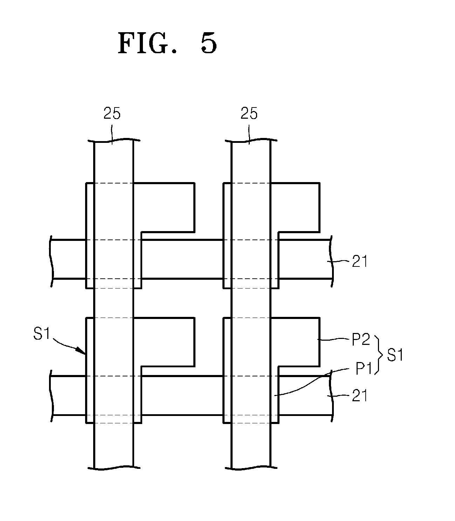

Referring back to FIGS. 2 and 3, the first and second structures S1 and S2 are illustrated as having cylindrical shapes, but the shapes may be variously changed, e.g., a square pillar shape or a shape where the width increases towards its lower portion. For example, the first and second stack structures S1 and S2 may have asymmetrical shapes that extend out of the intersections between the first and second electrodes 21 and 25 and the intersections between the second and third electrodes 25 and 29. An example of the stack structures S1 having the asymmetrical shape is illustrated in FIG. 5.

Referring to FIG. 5, the first stack structures S1 may each include a first portion P1 that may be disposed at an intersection between the first and second electrodes 21 and 25, and a second portion P2 that may be in contact with the first portion P1 and extends out of the intersection. For example, the stack structures S1 have asymmetrical shapes that extend out of the intersections between the first and second electrode 21 and 25. In example embodiments, the first switch structure 24 and the first memory resistor 22 may have different shapes. For example, the first switch structure 24 may have an area corresponding to the first portion P1 and the second portion P2, and the first memory resistor 22 may have an area corresponding to the first portion P1. When the first switch structure 24 is a diode, as the area of the first switch structure 24 increases, the amount of a forward current flowing through the first switch structure 24 may increase, and accordingly, the switching characteristics may improve. Although not illustrated, the planar structures of the second stack structures S2 may be similar to those of the stack structures S1 illustrated in FIG. 5. Although not illustrated, the resistive memory array of FIG. 3 may further include a stack structure having the same stack structure as the stack structures S1 and the second electrode 25 on the third electrodes 29.

According to example embodiments, the resistive memory array may further include at least one stack structure on the third electrodes 29, wherein in the stack structure, the first stack structures S1, the second electrodes 25, the second stack structures S2 and the third electrodes 29 may be sequentially formed. In addition, the resistive memory array according to example embodiments may further include at least one stack structure on the third electrodes 29, wherein in the stack structure, the first stack structures S1, the second electrodes 25, the second structures S2, the third electrodes 29, the first stack structures S1 and the second electrode 25 may be sequentially formed. The resistive memory array according to example embodiments may be a multi-layer cross point memory device having a 1 D-1 R cell structure.

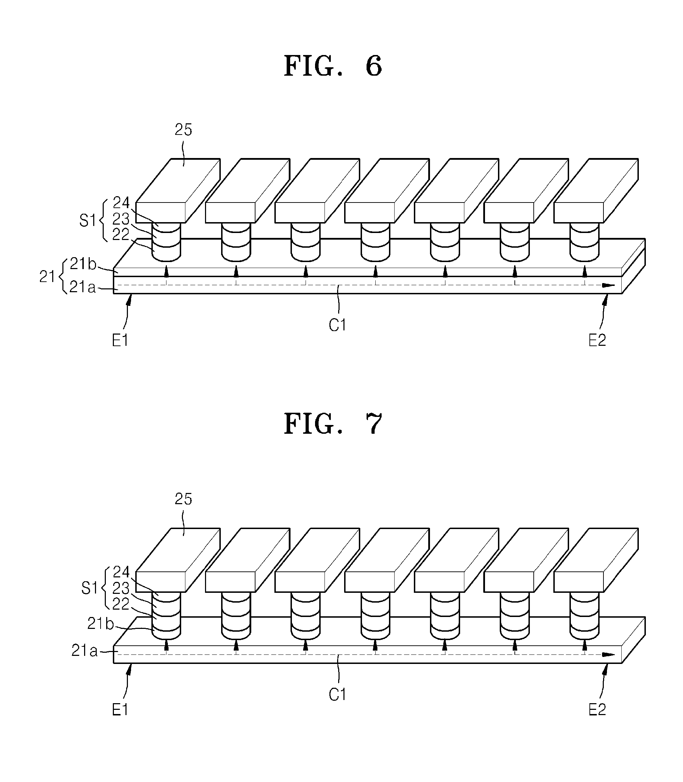

FIG. 6 illustrates a partial structure of FIGS. 2 and 3. A phenomenon whereby a problem with a drop in voltage may be overcome in example embodiments will now be described with reference to FIG. 6. Referring to FIG. 6, the first electrode 21 may have a dual-layer structure including the first conductive layer 21 a and the second conductive layer 21 b. In addition, the first stack structures S1 may be disposed on the second conductive layer 21 b. The second electrodes 25 that cross the first electrode 21 may be disposed on the first stack structures S1. When a current C1 is supplied to the first memory resistor 22 via the first electrode 21, the current C1 may primarily flow through the first conductive layer 21 a. This may be because the specific resistance of the first conductive layer 21 a may be lower than that of the second conductive layer 21 b. If the first electrode 21 has a single-layer composed of only a material used for forming the second conductive layer 21 b, because the material of the second conductive layer 21 b has relatively high specific resistance, a drop in voltage may more easily occur away from one end E1 of the first electrode 21 towards the other end E2 of the first electrode 21.

Thus, when the first electrode 21 has a single-layer structure composed of only the material of the second conductive layer 21 b, applying a desired amount of voltage to the first stack structures S1 may be difficult. As a result, power consumption may be increased, and the memory device may not easily operate. However, in example embodiments, when the first electrode 21 may be configured to include a dual-layer structure in which the first conductive layer 21 a and the second conductive layer 21 b may be sequentially formed, the current C1 may primarily flow through the first conductive layer 21 a having relatively low specific resistance, thereby preventing or reducing the problem with a drop in voltage.

In addition, in example embodiments, when the first electrode 21 including the first conductive layer 21 a together with the second conductive layer 21 b is used, the manufacturing costs of the memory device may be reduced compared to the case of a single-layer electrode formed of the material (e.g., expensive noble metal) used for forming the second conductive layer 21 b. The second conductive layer 21 b may be required because the interfacial characteristics between the first memory resistor 22 and the first conductive layer 21 a may be undesirable when the first memory resistor 22 is directly in contact with the first conductive layer 21 a. For example, the second conductive layer 21 b may be required for ensuring the contact characteristic between the first conductive layer 21 a and the first memory resistor 22. Minimizing or reducing the thickness of the second conductive layer 21 b may be economical.

The second electrode 25 may have a reverse structure of the first electrode 21, and may have the same stack structure as the first electrode 21. The stack structure of the second electrode 25 may change according to a material layer formed on the second electrode 25. When an n-type semiconductor layer is formed on the second electrode 25, the second electrode 25 may have the reverse structure of the first electrode 21. If an n-type semiconductor layer is directly formed on a noble metal conductive layer having relatively high specific resistance in the second electrode 25, the interfacial characteristics between the n-type semiconductor layer and the noble metal conductive layer may be undesirable. When a p-type semiconductor layer is formed on the second electrode 25, the second electrode 25 may have the same stack structure as the first electrode 21. A noble metal conductive layer having relatively high specific resistance may be directly in contact with the p-type semiconductor layer without difficulty. Due to the second electrode 25, a problem with a drop in voltage may be prevented or reduced, and manufacturing costs may be reduced.

FIG. 7 illustrates a modified example of the memory array illustrated in FIG. 6. Referring to FIG. 7, the second conductive layer 21 b may be patterned so as to have the planar structures similar to those of the stack structures S1. That is, the second conductive layer 21 b illustrated in FIG. 6 extends in a line pattern, but the second conductive layer 21 b illustrated in FIG. 7 may be configured as dot patterns disposed at intersections between the first conductive layer 21 a and the second electrode 25. Also in FIG. 7, due to the second conductive layer 21 b, the contact characteristics between the first conductive layer 21 a and the first memory resistor 22 may be ensured, and a problem with a drop in voltage may be minimized or reduced due to the first conductive layer 21 a. The modified structure of FIG. 7 may be applied to the array structures of FIGS. 2 and 3, and a noble metal conductive layer having relatively high specific resistance may also be patterned like the second conductive layer 21 b in the second electrode 25 and the third electrodes 29.

Even though noble metal layers are suggested as the second conductive layer 21 b and the third conductive layer 25a as described above, an alloy layer including a noble metal may be used as the second conductive layer 21 b and the third conductive layer 25a, according to example embodiments. For example, the second conductive layer 21 b and the third conductive layer 25a may be formed of an alloy including any one selected from Pt, Au, Pd, Ir and Ag, e.g., Pt-Ni, Pt-Ti, or Ir-Ti. In example embodiments, by virtue of the second conductive layer 21 b and the third conductive layer 25a, the operational characteristics (switching characteristics) of the memory device may be ensured, and the material of the first conductive layer 21 a may have lower specific resistance and may be more inexpensive than the material of the second conductive layer 21 b, and the material of the fourth conductive layer 25b may have lower specific resistance and be more inexpensive than the material of the third conductive layer 25a.

In addition, the memory array according to example embodiments may be used as a rewritable memory or a one-time programmable (OTP) memory. When the first and second memory resistors 22 and 28 each include a first element that may be reversibly converted from a higher resistance state to a lower resistance state, or vice versa, the cross point memory array according to example embodiments may be a rewritable memory. An example of the first element may be a material layer formed of the above-described variable resistance material or a filament fuse. On the other hand, the first and second memory resistors 22 and 28 may each include a second element that may be irreversibly converted from a higher resistance state to a lower resistance state, because a memory cell that is once programmed may not be restored back to an original state, the cross point memory array according to example embodiments may be an OTP memory. An example of the second element may be an antifuse that may be formed of an oxide or a nitride, for example, silicon oxide, silicon nitride, or aluminum oxide.

While example embodiments have been particularly shown and described with reference to embodiments thereof, they should not be construed as being limited to the embodiments set forth herein but as examples. It will be obvious to one of ordinary skill in the art that, for example, the constituent elements of the memory array may be varied and the structure of the memory array may also be modified. In addition, it will be obvious to one of ordinary skill in the art that the first and second electrodes 21 and 25 illustrated in FIGS. 1A and 1B and having the multi-layer structure may be applied to various semiconductor devices. Therefore, the scope of example embodiments is defined not by the detailed description of example embodiments but by the appended claims.

## Claims

1. A cross point memory array comprising:
a plurality of first electrode lines arranged parallel to each other;
a plurality of second electrode lines crossing the first electrode lines and arranged parallel to each other; and
a first memory resistor at intersections between the first electrode lines and the second electrode lines,
wherein at least one of the first electrode lines and the second electrode lines have a multi-layer structure including a first conductive layer and a second conductive layer formed of a noble metal or noble metal alloy.

2. The array of claim 1, wherein the specific resistance of the first conductive layer is lower than the specific resistance of the second conductive layer.

3. The array of claim 1 or 2, wherein the first conductive layer is formed of any one selected from Al, Mo, Cu and Ag.

4. The array of any preceding claim, wherein the noble metal is any one selected from Pt, Au, Pd, Ir and Ag.

5. The array of any preceding claim, wherein the first memory resistor includes at least one selected from Ni oxide, Cu oxide, Ti oxide, Co oxide, Hf oxide, Zr oxide, Zn oxide, W oxide, Nb oxide, TiNi oxide, LiNi oxide, Al oxide, InZn oxide, V oxide, SrZr oxide, SrTi oxide, Cr oxide, Fe oxide and Ta oxide.

6. The array of any preceding claim, further comprising:
a plurality of third electrode lines crossing the second electrode lines and arranged parallel to each other; and
a second memory resistor at intersections between the second electrode lines and the third electrode lines,
wherein the third electrode lines have a multi-layer structure including the first conductive layer and the second conductive layer.

7. The array of claim 1, wherein the second conductive layer is configured as dot patterns at the intersections.

8. The array of any preceding claim, further comprising:
a first switch structure for adjusting a current flow towards the first memory resistor at the intersections between the first electrode lines and the second electrode lines.

9. The array of claim 8 when dependent on claim 5, further comprising:
a second switch structure for adjusting a current flow towards the second memory resistor at the intersections between the second electrode lines and the third electrode lines.

10. The array of claim 8 or 9, further comprising:
a first or second intermediate electrode between the respective first or second memory resistor and the respective first or second switch structure.

11. The array of claim 10, wherein the first or second memory resistor, the first or second intermediate electrode, the first or second switch structure and the second or third electrode line are sequentially formed on the first or second electrode lines respectively, or wherein the first or second switch structure, the first or second intermediate electrode, the first or second memory resistor and the second or third electrode line are sequentially formed on the first or second electrode lines respectively.

12. The array of any of claims 7 to 11, wherein the first or second switch structure is any one selected from a diode, a threshold switching device, and a varistor.

13. The array of claim 12, wherein the switch structure is an oxide diode.

14. The array of any preceding claim, wherein the array is a multi-layer cross point array device having a one diode-one resistor (1 D-1 R) cell structure.

15. The array of any preceding claim, wherein the first memory resistor includes an element that is irreversibly or reversibly converted from a higher resistance state to a lower resistance state, or from a lower resistance state to a higher resistance state.
